# EUROPÄISCHE PATENTSCHRIFT

(11) **EP 3 194 639 B1**
(45) Veröffentlichungstag und Bekanntmachung des Hinweises auf die Patenterteilung: **13.03.2019**
(21) Anmeldenummer: 16797904.6
(22) Anmeldetag: 17.11.2016
(51) Int. Cl.: C25B 1/04, C25B 1/34, C25B 11/03, C25B 11/04, C02F 1/461, B01J 23/755, B01J 35/00, B01J 35/08, H01L 49/02, H01L 31/0224, H01M 4/66, H01M 4/80

(54) **NICKELELEKTRODE, FREITRAGENDE NICKELSCHICHT, VERFAHREN ZU DEREN HERSTELLUNG UND DEREN VERWENDUNG**
NICKEL ELECTRODE, SELF-SUPPORTING NICKEL LAYER, METHOD FOR PRODUCING SAME, AND USE OF SAME
ÉLECTRODE DE NICKEL, COUCHE DE NICKEL AUTOPORTEUSE, AINSI QUE PROCÉDÉ DE FABRICATION ET UTILISATION ASSOCIÉS

(30) Priorität: 19.11.2015 DE 102015120057
(43) Veröffentlichungstag der Anmeldung: 26.07.2017
(73) Patentinhaber: Zentrum für Sonnenenergie- und Wasserstoff-Forschung Baden-Württemberg Gemeinnützige Stiftung, 70565 Stuttgart (DE)
(72) Erfinder: JÖRISSEN, Ludwig, 89231 Neu-Ulm (DE); ASANTE, Jerry Bamfo, 89077 Ulm (DE); BÖSE, Olaf, 89233 Neu-Ulm (DE)
(74) Vertreter: Ter Meer Steinmeister & Partner
(86) Internationale Anmeldenummer: PCT/EP2016/077978
(87) Internationale Veröffentlichungsnummer: WO 2017/085173

(56) Entgegenhaltungen:
- DE-A1- 2 002 298
- DE-A1- 3 612 790
- DE-T2- 69 911 150
- US-A1- 2002 150 821
- US-A1- 2015 203 976

## Beschreibung

### Gebiet der Erfindung

Die Erfindung betrifft eine Nickelelektrode mit einer Nickelschicht hoher Oberfläche aus sphärischen, porösen Nickelpartikeln, eine freitragende Nickelschicht hoher Oberfläche aus sphärischen, porösen Nickelpartikeln, Verfahren zur Herstellung der Nickelelektrode und der freitragenden Nickelschicht und deren Verwendung, insbesondere als Elektrode für die Wasserelektrolyse.

### Technischer Hintergrund und Stand der Technik

Generell ist es schwierig, festanhaftende Schichten von Nickel-Partikeln auf Nickelblechen ohne Anwendung eines Anpressdrucks bei erhöhter Temperatur herzustellen. Die gebildeten Schichten lösen sich üblicherweise sehr leicht vom Träger, dem Nickelblech wieder ab. Ein Sinterprozess würde einen hohen Anpressdruck bei erhöhter Temperatur erfordern und stellt daher einen aufwendigen und kostspieligen Vorgang dar. Gesinterte Nickelelektroden werden seit 1928 u.a. für Nickel-Cadmium Akkumulatoren genutzt und erfordern Sintertemperaturen im Bereich 800-1000 °C (AK Shukla, B Hariprakash in SECONDARY BATTERIES - NICKEL SYSTEMS, Electrodes: Nickel. Seite 407, Elsevier, 2009).

Die US 4,605,484 beschreibt eine Elektrode zur Wasserstoffentwicklung, umfassend ein elektrisch leitfähiges Substrat mit einer darauf befindlichen Beschichtung aus einer Chromkomponente und einem Oxid mindestens eines Metalls aus Nickel und Kobalt, wobei die Beschichtung durch Schmelzsprühen mittels eines aufwendigen Plasmasprühverfahrens hergestellt wird.

Die EP 0 226 291 A1 beschreibt ein Verfahren zur Verlängerung der Gebrauchsdauer einer Elektrode zur Wasserstoffentwicklung, die ein elektrisch leitfähiges Substrat und eine Beschichtung aus einem Metalloxid umfasst, wobei dem alkalischen Elektrolyten während der Wasserstoffentwicklung eine Metallkomponente aus beispielsweise Titan oder Niob zugesetzt wird. Die Metalloxidbeschichtung auf der Elektrode kann beispielsweise durch Plasma- oder Flammsprühen hergestellt werden.

Die DE 2 002 298 beschreibt ein Verfahren zur Herstellung von Elektroden für die technische Wasserelektrolyse durch Aufbringen einer porösen Nickelschicht auf eine metallische Unterlage, wobei die poröse Nickelschicht in einer wässrigen Lösung von Alkalikarbonaten oder Alkalihydrogenkarbonaten anodisch oxidiert und das gebildete Oxidationsprodukt anschließend zu feinverteiltem metallischen Nickel reduziert wird. Die poröse Nickelschicht wird durch Flammspritzen oder Lichtbogenspritzen von metallischem Nickel auf eine aufgeraute metallische Unterlage erzeugt.

Verschiedene Nickelelektroden sind kommerziell erhältlich. Beispielsweise bekannt sind Nickel-Sinterelektroden mit stäbchenförmigen Nickelpartikeln (siehe Fig. 1 aus Morioka Y., Narukawa S., Itou T., Journal of Power Sources 100 (2001): 107-116), Nickelschaum-Elektroden mit einer wabenartigen Struktur (siehe Fig. 2) oder Nickel-Faserelektroden mit zylindrischen Nickelfasern (siehe Fig. 3 aus Ohms D., Kohlhase M., Benczur-Urmossy G., Schadlich G., Journal of Power Sources 105 (2002): 127-133.).

Die vorgenannten, kommerziell erhältlichen Nickelelektroden dienen als Elektroden für Batterien und sind zur Aufnahme von Aktivmaterial optimiert.

US 2015/203976 A1, DE 36 12 790 A1, US 2002/150821 A1 und DE 699 11 150 T2 offenbaren weitere Elektroden.

### Aufgabe der Erfindung

Der Erfindung liegt die Aufgabe zugrunde, unter Vermeidung der Nachteile des Standes der Technik eine Nickelelektrode vorzusehen, die eine festanhaftende Nickelschicht auf einem elektrisch leitfähigen Träger aus Nickelblech aufweist und eine hohe mechanische Stabilität besitzt. Ferner soll die Nickelelektrode vorteilhafte elektrochemische Eigenschaften aufweisen, insbesondere bei der Wasserelektrolyse eine verstärkte Sauerstoff- und Wasserstoffentwicklung ermöglichen.

Ebenso soll eine freitragende Nickelschicht mit vorteilhaften Eigenschaften vorgesehen werden, insbesondere vorteilhaften elektrochemischen Eigenschaften für die Wasserelektrolyse.

Des Weiteren soll ein einfaches und kostengünstiges Verfahren zur Herstellung der vorgenannten Nickelelektrode sowie der vorgenannten freitragenden Nickelschicht vorgesehen werden. Insbesondere im Falle der Herstellung von Nickelelektroden sollen auf dem Nickelblech fest anhaftende Nickelschichten erzielt werden.

### Zusammenfassung der Erfindung

Die vorgenannten Aufgaben werden erfindungsgemäß gelöst durch eine Nickelelektrode gemäß Anspruch 1, eine freitragende Nickelschicht gemäß Anspruch 2, ein Verfahren zur Herstellung der Nickelelektrode gemäß Anspruch 9, ein Verfahren zur Herstellung der freitragenden Nickelschicht gemäß Anspruch 10 sowie die Verwendung der Nickelelektrode und der freitragenden Nickelschicht gemäß den Ansprüchen 11 und 12.

Bevorzugte bzw. besonders zweckmäßige Ausführungsformen des Anmeldungsgegenstandes sind in den Unteransprüchen angegeben.

### Detaillierte Beschreibung der Erfindung

Die erfindungsgemäße Nickelelektrode und die erfindungsgemäße freitragende Nickelschicht zeichnen sich aus durch eine Nickelschicht aus aneinander haftenden, sphärischen, porösen Nickelpartikeln, die eine größere innere Oberfläche aufweisen als bisher im Handel erhältliche Nickelelektroden für Batterien, wie Schaum-, Sinter- oder Faserelektroden. Nickelelektroden mit einer Nickelschicht aus sphärischen, porösen Nickelpartikeln sind in der industriellen Praxis bisher nicht bekannt. Überraschenderweise hat sich gezeigt, dass die erfindungsgemäßen Nickelelektroden und die erfindungsgemäßen freitragenden Nickelschichten insbesondere in vorteilhafterweise für die Wasserelektrolyse in einem alkalischen Medium eingesetzt werden können und hierbei zu einer deutlich verstärkten Gasentwicklung bei der Sauerstofferzeugung und insbesondere bei der Wasserstofferzeugung fähig sind. Dieser überraschende Effekt der Verstärkung der Gasentwicklung ist offensichtlich der hohen inneren Oberfläche der Nickelschichten zuzuschreiben. Aufgrund der hohen inneren Oberfläche ist der Übergangswiderstand der Elektrode zum umgebenden Medium sehr gering, wodurch die erreichbaren Stromdichten zum Beispiel in der Wasserhydrolyse größer sind als im Vergleich zu unbeschichteten Nickelblechen.

Das erfindungsgemäße Verfahren ermöglicht es durch einfache Prozessschritte, wie druckloses Beschichten bei Raumtemperatur und anschließendes Tempern der beschichteten Nickelbleche zu fest anhaftendenen Schichten aus Nickelpartikeln auf den Nickelblechen zu gelangen. Die so hergestellten Nickelelektroden weisen eine hohe mechanische Stabilität auf, wobei die Schichten aus sphärischen Nickelpartikeln auch während und nach einer mechanischen Verformung der Nickelbleche haften bleiben. In Peeltests können Haltekräfte von bis zu 350 N nachgewiesen werden, welche durch Variation der Verfahrensparameter weiter erhöht werden können.

Des Weiteren hinterlassen die eingesetzten Bindemittel keine störenden Kohlenstoffablagerungen auf der Oberfläche der Nickelschichten, da sie rückstandsfrei verdampfbar sind.

Die erfindungsgemäß eingesetzten, sphärischen Nickelhydroxid-Partikel sind als Batteriematerial kommerziell verfügbar (zum Beispiel bei Fa. Umicore, Belgien und Fa. Tanaka, Japan) und weisen vorzugsweise eine mittlere Partikelgröße von 0,3 - 75 µm, weiter vorzugweise 3 - 30 µm, insbesondere vorzugsweise 9 - 12 µm auf. Am meisten bevorzugt sind solche mit einer mittleren Partikelgröße von etwa 10 µm.

Die partielle Reduzierung im Schritt b) des erfindungsgemäßen Verfahrens wird bei Temperaturen von 270 - 330 °C, weiter vorzugsweise von 290 - 310 °C durchgeführt.

Die partielle Reduzierung erfolgt geeigneterweise über einen Zeitraum von 3 bis 5 Stunden bei den vorgenannten Bedingungen.

Sowohl die partielle Reduzierung im Schritt b) als auch die Temperung im Schritt e) des erfindungsgemäßen Verfahrens erfolgt in einer reduzierenden Atmosphäre, umfassend beispielsweise 10-100 % Wasserstoff und gegebenenfalls ein Inertgas, wie Stickstoff, wenn die reduzierende Atmosphäre nicht aus 100% Wasserstoff besteht.

Als organische Bindemittel zur Herstellung einer Paste mit den durch partielle Reduzierung erhaltenen Ni/NiO-Partikeln eignen sich insbesondere natürliche und/oder synthetische Polymere oder Derivate davon. Beispielsweise geeignet sind Alkydharze, Cellulose und deren Derivate, Epoxidharze, Polyacrylate, wie etwa Polymethylmethacrylat (PMMA) und Polyacrylsäure (PAA), Polychlortrifluorethylen (PCTFE), Polyhexafluorpropylen (PHFP), Polyimide (PI) und deren Derivate, Polyurethane (PU) und deren Derivate, Polytetrafluorethylen (PTFE), Polytrifluorethylen (PTrFE), Polyvinylalkohol (PVA), Polyvinylidendifluorid (PVDF), Silicone, Stärke und deren Derivate, Styrol-Butadien-Gummi (SBR) und Mischungen aus den vorgenannten Materialien. Besonders bevorzugte organische Bindemittel sind Polyvinylalkohole.

Für die Pastenherstellung können gegebenenfalls weitere übliche Hilfsstoffe zugesetzt werden, wie organische oder anorganische Lösungsmittel, Dispergierhilfsmittel oder Tenside.

Als anorganische Bindemittel eignen sich insbesondere Ammoniumsalze oder Hydrazinsalze in wässrigen Medien.

Das abschließende Tempern des beschichteten Nickelblechs oder des beschichteten Trägers erfolgt bei Temperaturen im Bereich von 500-800°C, weiter vorzugsweise von 600-700°C. Die abschließende Temperung erfolgt typischerweise über einen Zeitraum von 3 bis 5 Stunden. Die abschließende Temperung dient zur vollständigen Reduktion der Ni/NiO-Partikel zur Erzielung einer Nickelschicht aus fest aneinander haftenden, sphärischen, porösen Nickelpartikeln. Ferner soll sichergestellt werden, dass die eingesetzten Bindemittel und gegebenenfalls Hilfsstoffe vollständig entfernt werden bzw. rückstandsfrei verdampfen.

Die Nickelschicht der erfindungsgemäßen Nickelelektrode oder die erfindungsgemäße freitragende Nickelschicht weist vorzugsweise eine Dicke im Bereich von 1-1.000 µm, weiter vorzugsweise 10-900 µm, und insbesondere bevorzugt 20-200 µm, auf.

Die sphärischen, porösen Nickelpartikel weisen eine mittlere Partikelgröße von 0,1-25 µm, weiter vorzugsweise 1-10 µm, noch weiter vorzugsweise 2-6 µm, und insbesondere bevorzugt 3-4 µm, auf.

Bei der Herstellung freitragender Nickelschichten werden als Träger geeigneterweise Metallfolien, Metallschäume, Metallnetze, Streckmetalle, Kohlenstofffolien, Kohlenstoffschäume, Polymerfolien oder keramische Träger eingesetzt.

Bei der Auswahl der Träger ist darauf zu achten, dass sich diese wieder von der freitragenden Nickelschicht entfernen lassen. Metallische Träger, wie beispielsweise Aluminiumfolien, lassen sich im Nachgang durch Säure- oder Alkalibehandlung auflösen, sodass die freitragende, poröse Nickelschicht bestehen bleibt. Im Falle von Polymerfolien ist beispielsweise eine oxidative Entfernung der Folien nach der Temperung duchführbar. Erfindungsgemäß ist auch eine Dotierung der Nickelschichten aus porösen Nickelpartikeln möglich. Die Dotierung der Partikel mit Fremdionen kann vor, während oder nach dem Tempern erfolgen.

Die erfindungsgemäßen Nickelelektroden finden insbesondere Verwendung als Arbeitselektrode in Batterien, Akkumulatoren, symmetrischen und asymmetrischen Doppelschichtkondensatoren, Sensoren, als Katalysatorträger, als Elektroden in elektrochemischen Synthesen oder in fotoelektrischen und fotokatalytischen Geräten, insbesondere für die Wasserelektrolyse in einem alkalischen Medium.

Einbezogen sind insbesondere Anwendungen in der Elektrolyse, wie etwa Chlor-Alkali-Elektrolyse, Katalyse, in fotovoltaischen Beschichtungen als auch bei der fotovoltaischen Wasserstofferzeugung.

Die erfindungsgemäßen freitragenden Nickelschichten können prinzipiell als freitragende Elektroden verwendet werden. Insbesondere bevorzugt ist jedoch die Verwendung als Elektrode für die Elektrolyse von Wasser, bei der es heutzutage auch möglich ist, vollständig poröse Elektroden einzusetzen.

### Kurze Beschreibung der Zeichnungen

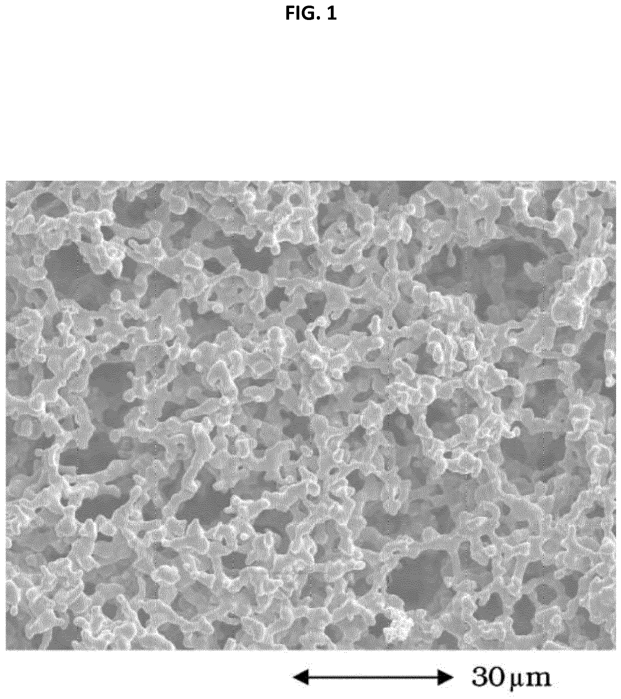

**Fig. 1** zeigt eine REM(Rasterelektronen-Mikroskopie)-Aufnahme der Oberfläche einer kommerziellen Nickel-Sinterelektrode bei 1000-facher Vergrößerung. (aus Morioka Y., Narukawa S., Itou T., Journal of Power Sources 100 (2001): 107-116);

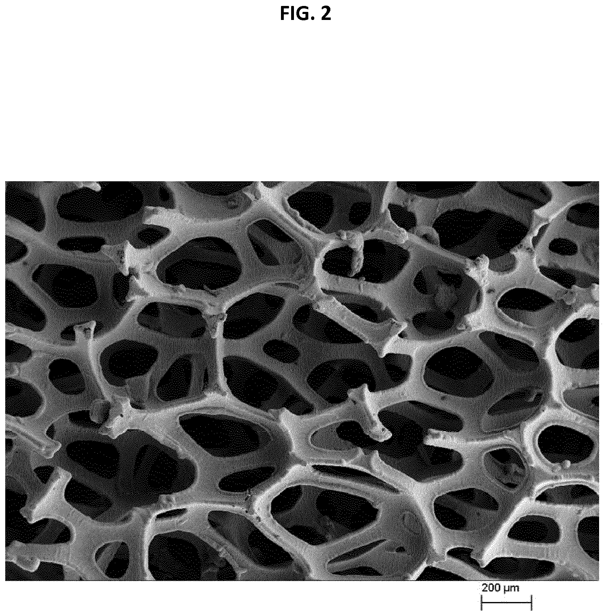

**Fig. 2** zeigt eine REM-Aufnahme der Oberfläche einer kommerziellen Nickel-Schaumelektrode mit wabenartiger Struktur bei 150-facher Vergrößerung;

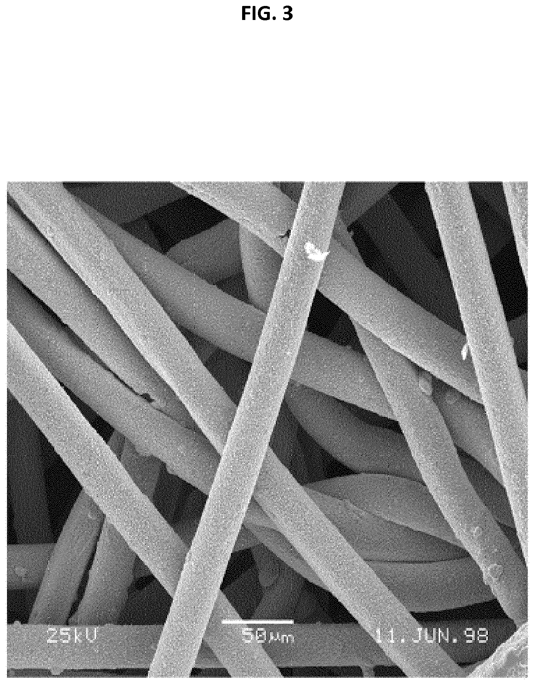

**Fig. 3** zeigt eine REM-Aufnahme der Oberfläche einer kommerziellen Nickel-Faserelektrode bei 500-facher Vergrößerung. (aus Ohms D., Kohlhase M., Benczur-Urmossy G., Schadlich G., Journal of Power Sources 105 (2002): 127-133);

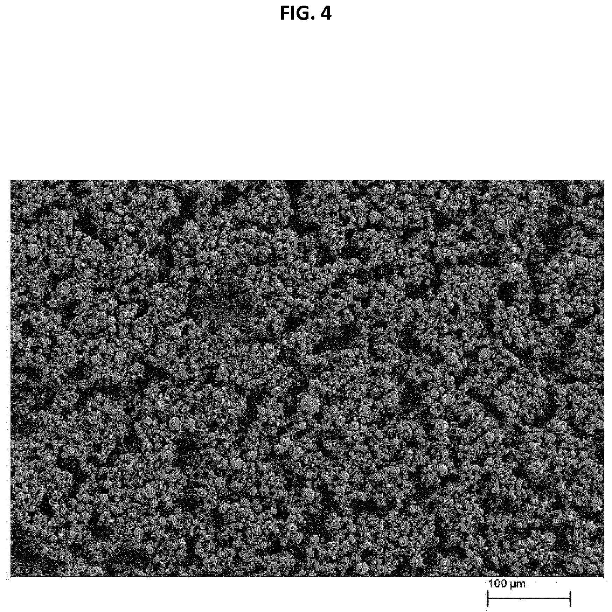

**Fig. 4** zeigt eine REM-Aufnahme der Oberfläche einer erfindungsgemäßen Nickelelektrode 500-facher Vergrößerung;

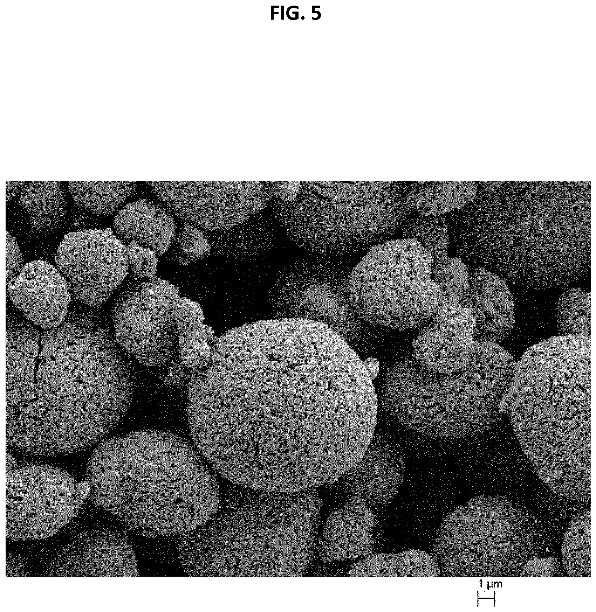

**Fig. 5** zeigt eine REM-Aufnahme der Oberfläche einer erfindungsgemäßen Nickelelektrode bei 10.000-facher Vergrößerung;

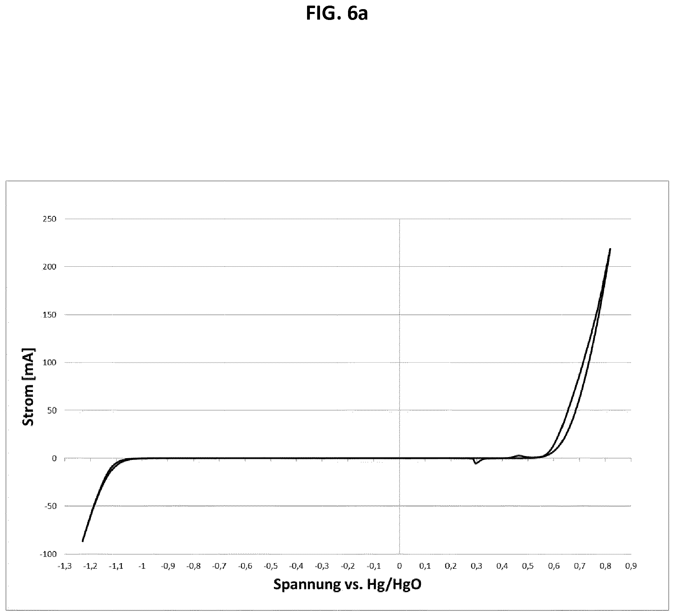

**Fig. 6a** zeigt ein quasistationäres Zyklovoltammogramm mit einer Scanrate von 50 µV s⁻¹ an einer erfindungsgemäßen 1 cm²-Nickelelektrode zur Wasserelektrolyse in einem Elektrolyten aus 5,5M KOH; 2,5M NaOH und 0,5M LiOH bei Raumtemperatur. Die Rückseite der Elektrode ist elektrisch isolierend mit Epoxidharz beschichtet;

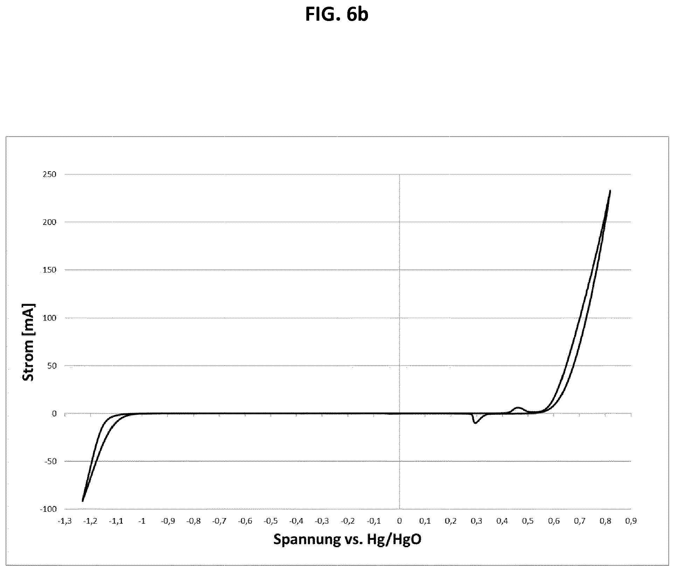

**Fig. 6b** zeigt ein quasistationäres Zyklovoltammogramm mit einer Scanrate von 100 µV s⁻¹ an einer erfindungsgemäßen 1 cm²-Nickelelektrode zur Wasserelektrolyse in einem Elektrolyten aus 5,5M KOH; 2,5M NaOH und 0,5M LiOH bei Raumtemperatur. Die Rückseite der Elektrode ist elektrisch isolierend mit Epoxidharz beschichtet;

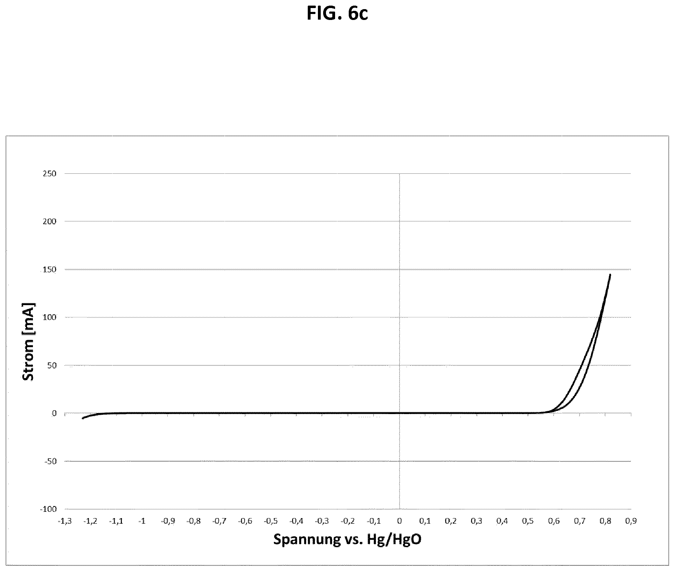

**Fig. 6c** zeigt ein quasistationäres Zyklovoltammogramm mit einer Scanrate von 50 µV s⁻¹ an einer planen und unbehandelten 1 cm²-Nickelelektrode zur Wasserelektrolyse in einem Elektrolyten aus 5,5M KOH; 2,5M NaOH und 0,5M LiOH bei Raumtemperatur. Die Rückseite der Elektrode ist elektrisch isolierend mit Epoxidharz beschichtet;

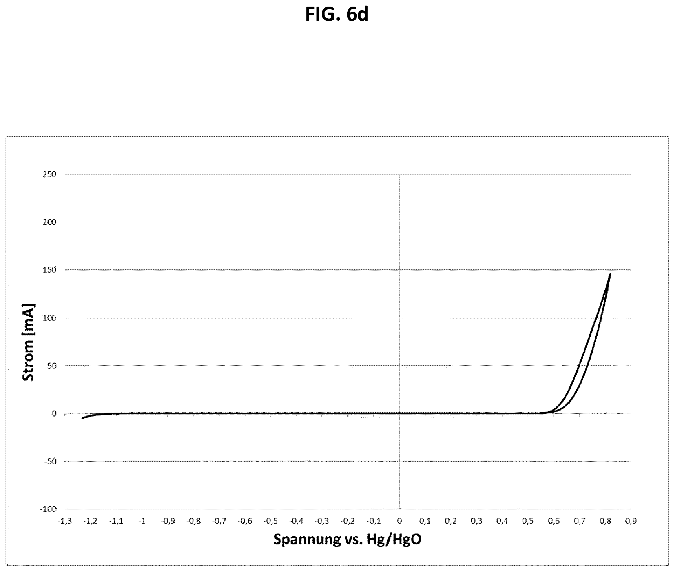

**Fig. 6d** zeigt ein quasistationäres Zyklovoltammogramm mit einer Scanrate von 100 µV s⁻¹ an einer planen und unbehandelten 1 cm²-Nickelelektrode zur Wasserelektrolyse in einem Elektrolyten aus 5,5M KOH; 2,5M NaOH und 0,5M LiOH bei Raumtemperatur. Die Rückseite der Elektrode ist elektrisch isolierend mit Epoxidharz beschichtet.

### Bevorzugte Ausführungsformen und Ausführungsbeispiel

### Herstellung einer erfindungsgemäßen Nickelelektrode

50 g sphärische β-Ni(OH)₂-Partikel werden bei einer Temperatur von 300 °C für 4 Stunden in einer Atmosphäre aus 50 Vol.% Wasserstoff in Stickstoff in einem Glühofen partiell reduziert, wobei der durchschnittliche Partikeldurchmesser von etwa 10 µm erhalten blieb. Diese partiell reduzierten, sphärischen Ni/NiO-Partikel weisen bereits eine innere Porenstruktur auf.
5 g der partiell reduzierten, sphärischen Ni/NiO-Partikel werden mit 3 ml einer 7,5 Gew.-% wässrigen Polyvinylalkohollösung zu einer Paste angeteigt, die anschließend einseitig auf 125 µm Nickelblech beschichtet wird.

Nach einer abschließenden Temperung im Glühofen bei einer Temperatur von 620 °C in einer reduzierenden Atmosphäre aus 50 Vol.% Wasserstoff in Stickstoff ist die gebildete Elektrode einsetzbar. Die sphärischen Nickelpartikel, die auf dem Nickelblech aufgebracht wurden, haben einen durchschnittlichen Durchmesser von 3,4 µm und weisen eine innere Porenstruktur auf.

In der nachfolgenden Tabelle 1 sind die mittleren Partikelgrößen der eingesetzten Nickelhydroxid-Partikel, der partiell reduzierten Ni/NiO-Partikel sowie der sphärischen, porösen Nickelpartikel der Nickelschicht zusammengefasst.

**Tabelle 1**

| Probe | Mittlere Partikelgröße [µm] |
|---|---|
| β-Ni(OH)₂ | 10,1 |
| Partiell reduziertes Ni/NiO | 10,3 |
| Ni-Partikel auf Ni-Blech beschichtet | 3,4 |

### Sauerstoffentwicklung

Aufgrund der hohen inneren Oberfläche ist der Übergangswiderstand der erfindungsgemäßen Elektrode zum umgebenen Medium sehr gering und damit die erreichbare Stromdichte z.B. in der Wasserhydrolyse größer als im Vergleich zu unbeschichteten Nickelblechen. In unbeschichteten Nickelblechen werden Stromdichten im Bereich von 144 mA/cm² bei einer Spannung von 0,819 V gegenüber der Hg/HgO-Referenzelektrode und Spannungsänderungen im Bereich von 50 bis 100 µV/s in einem Elektrolyten aus 5,5M KOH, 2,5M NaOH und 0,5M LiOH erhalten. Die geringe Spannungsänderung kann als quasistatische Messung betrachtet werden. Das gewählte Potential von 0,819 V gegenüber der Hg/HgO-Referenz ist alleinig der Sauerstoffentwicklung zuzurechnen. Bei nach dem erfindungsgemäßen Verfahren hergestellten oberflächenreichen Nickelelektroden werden unter den gleichen Bedingungen Stromdichten von zwischen 218-232 mA/cm² gefunden. Das entspricht einer mittleren Verstärkung der Stromdichte um einen Faktor von etwa 1,5 (siehe Tab.2). Die entsprechenden Zyklovoltammogramme sind in Fig. 6 a-d zu finden.

**Tabelle 2**

| Probe | Stromdichte [mA/cm²] bei 50 µV/s | Stromdichte [mA/cm²] bei 100 µV/s |
|---|---|---|
| Ni-Blech unbeschichtet; Rückseite mit Epoxidharz abgedeckt | 144,65 | 144,81 |
| Ni-Blech mit 3,4 µm Ni-Partikeln beschichtet; Rückseite mit Epoxidharz abgedeckt | 218,67 | 232,81 |
| Mittlerer Verstärkungsfaktor | 1.5 | 1.6 |

### Wasserstoffentwicklung

Einen wesentlich größeren Effekt der Verstärkung der Gasentwicklung durch die erfindungsgemäßen oberflächenreichen Nickelelektroden ist für die Wasserstoffentwicklung zu beobachten. In unbeschichteten Nickelblechen werden Stromdichten im Bereich von 5 mA/cm² bei einer Spannung von -1,231 V gegenüber der Hg/HgO-Referenzelektrode und einer Spannungsänderung von 50 bis 100 µV/s in einem Elektrolyten aus 5,5M KOH, 2,5M NaOH und 0,5M LiOH erhalten. Die geringe Spannungsänderung kann als quasistatische Messung betrachtet werden. Das gewählte Potential von -1,231 V gegenüber der Hg/HgO-Referenz ist alleinig der Wasserstoffentwicklung zuzurechnen. Bei nach dem erfindungsgemäßen Verfahren hergestellten oberflächenreichen Nickelelektroden werden unter den gleichen Bedingungen Stromdichten von zwischen 86-91 mA/cm² gefunden. Das entspricht einer mittleren Verstärkung der Stromdichte um einen Faktor von etwa 17 (siehe Tab.3). Die entsprechenden Zyklovoltammogramme sind in Fig. 6 a-d zu finden.

**Tabelle 3**

| Probe | Stromdichte [mA/cm²] bei 50 µV/s | Stromdichte [mA/cm²] bei 100 µV/s |
|---|---|---|
| Ni-Blech unbeschichtet; Rückseite mit Epoxidharz abgedeckt | 5,35 | 4,92 |
| Ni-Blech mit 3,4 µm Ni-Partikeln beschichtet; Rückseite mit Epoxidharz abgedeckt | 86,49 | 91,29 |
| Mittlerer Verstärkungsfaktor | 16,2 | 18,55 |

## Patentansprüche

1. Nickelelektrode, umfassend ein elektrisch leitfähiges Nickelblech und eine darauf aufgebrachte Nickelschicht aus aneinander haftenden, sphärischen, porösen Nickelpartikeln mit einer mittleren Partikelgröße von 0,1 - 25 µm, die eine innere Porenstruktur und somit eine innere Oberfläche aufweisen, erhältlich durch ein Verfahren, umfassend folgende Schritte:
a) Vorsehen von sphärischen Nickelhydroxid-Partikeln,
b) partielle Reduzierung der sphärischen Nickelhydroxid-Partikel in einer reduzierenden Atmosphäre bei Temperaturen von 270-330°C zur Erzielung partiell reduzierter, sphärischer Ni/NiO-Partikel,
c) Herstellen einer Paste aus den erhaltenen Ni/NiO-Partikeln und einem organischen und/oder anorganischen Bindemittel sowie ggf. weiteren Hilfsstoffen,
d) Aufbeschichten der Paste auf eine oder beide Seiten des elektrisch leitfähigen Nickelblechs, und
e) Tempern des beschichteten Nickelblechs in einer reduzierenden Atmosphäre bei Temperaturen von 500-800°C.

2. Freitragende Nickelschicht aus aneinander haftenden, sphärischen, porösen Nickelpartikeln, die eine innere Porenstruktur und somit eine innere Oberfläche aufweisen, erhältlich durch ein Verfahren, umfassend folgende Schritte:
a) Vorsehen von sphärischen Nickelhydroxid-Partikeln
b) partielle Reduzierung der sphärischen Nickelhydroxid-Partikel in einer reduzierenden Atmosphäre bei Temperaturen von 270-330°C zur Erzielung partiell reduzierter, sphärischer Ni/NiO-Partikel,
c) Herstellen einer Paste aus den erhaltenen Ni/NiO-Partikeln und einem organischen und/oder anorganischen Bindemittel sowie ggf. weiteren Hilfsstoffen,
d) Aufbeschichten der Paste auf einen Träger,
e) Tempern des beschichteten Trägers in einer reduzierenden Atmosphäre bei Temperaturen von 500-800°C, und
f) Abtrennen des Trägers zur Erzielung der freitragenden porösen Nickelschicht.

3. Nickelelektrode oder freitragende Nickelschicht nach Anspruch 1 oder 2, wobei die im Schritt a) vorgesehenen sphärischen Nickelhydroxid-Partikel eine mittlere Partikelgröße von 0,3-75 µm, vorzugsweise 3-30 µm, weiter vorzugsweise 9-12 µm, insbesondere bevorzugt 10 µm, aufweisen.

4. Nickelelektrode oder freitragende Nickelschicht nach mindestens einem der vorangehenden Ansprüche, wobei die partielle Reduzierung im Schritt b) bei Temperaturen von 290 - 310 °C, durchgeführt wird.

5. Nickelelektrode oder freitragende Nickelschicht nach mindestens einem der vorangehenden Ansprüche, wobei die partielle Reduzierung im Schritt b) und die Temperung im Schritt e) in einer reduzierenden Atmosphäre, umfassend 10 - 100 % Wasserstoff und gegebenenfalls ein Inertgas, durchgeführt wird.

6. Nickelelektrode oder freitragende Nickelschicht nach mindestens einem der vorangehenden Ansprüche, wobei im Schritt c) als organische Bindemittel natürliche und/oder synthetische Polymere oder Derivate davon, und als anorganische Bindemittel Ammoniumsalze oder Hydrazinsalze eingesetzt werden.

7. Nickelelektrode oder freitragende Nickelschicht nach mindestens einem der vorangehenden Ansprüche, wobei die Nickelschicht der Nickelelektrode oder die freitragende Nickelschicht eine Dicke im Bereich von 1-1.000 µm, vorzugsweise 10-900 µm, weiter vorzugsweise 20-200 µm, aufweist.

8. Nickelelektrode oder freitragende Nickelschicht nach mindestens einem der vorangehenden Ansprüche, wobei die sphärischen, porösen Nickelpartikel eine mittlere Partikelgröße von 0,1-25 µm, vorzugsweise 1-10 µm, weiter vorzugsweise 2 - 6 µm, insbesondere bevorzugt 3-4 µm, aufweisen.

9. Verfahren zur Herstellung einer Nickelelektrode gemäß mindestens einem der Ansprüche 1 bis 8, umfassend folgende Schritte:
a) Vorsehen von sphärischen Nickelhydroxid-Partikeln,
b) partielle Reduzierung der sphärischen Nickelhydroxid-Partikel in einer reduzierenden Atmosphäre bei Temperaturen von 270-330°C zur Erzielung partiell reduzierter, sphärischer Ni/NiO-Partikel,
c) Herstellen einer Paste aus den erhaltenen Ni/NiO-Partikeln und einem organischen und/oder anorganischen Bindemittel sowie ggf. weiteren Hilfsstoffen,
d) Aufbeschichten der Paste auf eine oder beide Seiten des elektrisch leitfähigen Nickelblechs, und
e) Tempern des beschichteten Nickelblechs in einer reduzierenden Atmosphäre bei Temperaturen von 500-800°C.

10. Verfahren zur Herstellung einer freitragenden Nickelschicht nach mindestens einem der Ansprüche 2 bis 8, umfassend folgende Schritte:
a) Vorsehen von sphärischen Nickelhydroxid-Partikeln
b) partielle Reduzierung der sphärischen Nickelhydroxid-Partikel in einer reduzierenden Atmosphäre bei Temperaturen von 270-330°C zur Erzielung partiell reduzierter, sphärischer Ni/NiO-Partikel,
c) Herstellen einer Paste aus den erhaltenen Ni/NiO-Partikeln und einem organischen und/oder anorganischen Bindemittel sowie ggf. weiteren Hilfsstoffen,
d) Aufbeschichten der Paste auf einen Träger,
e) Tempern des beschichteten Trägers in einer reduzierenden Atmosphäre bei Temperaturen von 500-800°C, und
f) Abtrennen des Trägers zur Erzielung der freitragenden porösen Nickelschicht.

11. Verwendung der Nickelelektrode nach mindestens einem der Ansprüche 1 bis 8 als Arbeitselektrode in Batterien, Akkumulatoren, symmetrischen und asymmetrischen Doppelschichtkondensatoren, Sensoren, als Katalysatorträger, als Elektroden in elektrochemischen Synthesen oder in fotoelektrischen und fotokatalytischen Geräten, insbesondere für die Wasserelektrolyse in einem alkalischen Medium.

12. Verwendung der freitragenden Nickelschicht nach mindestens einem der Ansprüche 2 bis 8 als Elektrode für die Wasserelektrolyse.

## Claims

1. Nickel electrode, comprising an electrically conductive nickel sheet of metal and a nickel layer consisting of spherical, porous nickel particles adhering to each other deposited thereon with an average particle size of 0.1 - 25 µm, which have an inner porous structure and thus an inner surface, obtainable with a method comprising the following steps:
a) providing spherical nickel hydroxide particles,
b) partially reducing the spherical nickel hydroxide particles in a reducing atmosphere at temperatures of 270 - 330 °C to obtain partially reduced spherical Ni/NiO particles,
c) preparing a paste from the Ni/NiO particles obtained and an organic and/or inorganic binder as well as further excipients as required,
d) applying the paste in a layer to one or both sides of the electrically conductive nickel sheet of metal, and
e) tempering the coated nickel sheet of metal in a reducing atmosphere at temperatures of 500 - 800 °C.

2. Self-supporting nickel layer consisting of spherical, porous nickel particles which adhere to each other which have an inner porous structure and thus an inner surface, obtainable with a method comprising the following steps:
a) providing spherical nickel hydroxide particles,
b) partially reducing the spherical nickel hydroxide particles in a reducing atmosphere at temperatures of 270 - 330 °C to obtain partially reduced spherical Ni/NiO particles,
c) preparing a paste from the Ni/NiO particles obtained and an organic and/or inorganic binder as well as further excipients as required,
d) applying the paste in a layer to a carrier,
e) tempering the coated carrier in a reducing atmosphere at temperatures of 500 - 800 °C and
f) separating the carrier to obtain the self-supporting porous nickel layer.

3. Nickel electrode or self-supporting nickel layer according to claim 1 or 2, wherein the spherical nickel hydroxide particles provided in step a) have an average particle size of 0.3-75 µm, preferably 3-30 µm, more preferably 9-12 µm, particularly preferably 10 µm.

4. Nickel electrode or self-supporting nickel layer according to at least one of the preceding claims, wherein the partial reduction in step b) is carried out at temperatures of 290 - 310 °C.

5. Nickel electrode or self-supporting nickel layer according to at least one of the preceding claims, wherein the partial reduction in step b) and the tempering in step e) are carried out in a reducing atmosphere containing 10 - 100% hydrogen and optionally an inert gas.

6. Nickel electrode or self-supporting nickel layer according to at least one of the preceding claims, wherein in step c) natural and/or synthetic polymers or derivatives thereof are used as organic binders, and ammonium salts or hydrazine salts are used as inorganic binders.

7. Nickel electrode or self-supporting nickel layer according to at least one of the preceding claims, wherein the nickel layer of the nickel electrode or the self-supporting nickel layer has a thickness in the range of 1-1,000 µm, preferably 10-900 µm, more preferably 20-200 µm.

8. Nickel electrode or self-supporting nickel layer according to at least one of the preceding claims, wherein the spherical, porous nickel particles have an average particle size of 0.1-25 µm, preferably 1-10 µm, more preferably 2 - 6 µm, particularly preferably 3-4 µm.

9. Method for producing a nickel electrode according to at least one of claims 1 to 8, comprising the following steps:
a) providing spherical nickel hydroxide particles,
b) partially reducing the spherical nickel hydroxide particles in a reducing atmosphere at temperatures of 270 - 330 °C to obtain partially reduced spherical Ni/NiO particles,
c) preparing a paste from the Ni/NiO particles obtained and an organic and/or inorganic binder as well as further excipients as required,
d) applying the paste in a layer to one or both sides of the electrically conductive nickel sheet, and
e) tempering the coated nickel sheet in a reducing atmosphere at temperatures of 500 - 800 °C.

10. Method for producing a self-supporting nickel layer according to at least one of claims 2 to 8, comprising the following steps:
a) providing spherical nickel hydroxide particles,
b) partially reducing the spherical nickel hydroxide particles in a reducing atmosphere at temperatures of 270 - 330 °C to obtain partially reduced spherical Ni/NiO particles,
c) preparing a paste from the Ni/NiO particles obtained and an organic and/or inorganic binder as well as further excipients as required,
d) applying the paste in a layer to a carrier,
e) tempering the coated carrier in a reducing atmosphere at temperatures of 500 - 800 °C, and
f) separating the carrier to obtain the self-supporting porous nickel layer.

11. Use of the nickel electrode according to at least one of claims 1 to 8 as a working electrode in batteries, rechargeable batteries, symmetrical and asymmetrical dual-layer capacitors, sensors, as catalyst carriers, as electrodes in electrochemical syntheses or in photoelectric and photocatalytic devices, particularly for water electrolysis in an alkaline medium.

12. Use of the self-supporting nickel layer according to at least one of claims 2 to 8 as an electrode for water electrolysis.

## Revendications

1. Electrode de nickel comprenant une feuille de nickel électriquement conductrice et une couche de nickel déposée sur celle-ci, de particules de nickel poreuses sphériques adhérées avec une taille de particule moyenne de 0,1 à 25 µm, lesquelles comprennent une structure poreuse interne et ainsi une surface interne, pouvant être obtenue par un procédé comprenant les étapes consistant en:
a) la fourniture de particules sphériques d'hydroxyde de nickel,
b) la réduction partielle des particules sphériques d'hydroxyde de nickel en une atmosphère réductrice à des températures de 270 à 330 °C pour l'obtention de particules Ni / NiO sphériques partiellement réduites,
c) la fabrication d'une pâte à partir des particules de Ni / NiO obtenues et d'un liant organique et / ou inorganique et éventuellement d'autres excipients,
d) le revêtement de la pâte sur une ou les deux faces de la feuille de nickel électriquement conductrice, et
e) la récuisson la feuille de nickel revêtue dans une atmosphère réductrice à des températures de 500 à 800 °C.

2. Couche de nickel autoportante constituée de particules de nickel poreuses sphériques adhérées lesquelles comprennent une structure poreuse interne et ainsi une surface interne, pouvant être obtenue par un procédé comprenant les étapes consistant en:
a) la fourniture de particules sphériques d'hydroxyde de nickel
b) la réduction partielle des particules sphériques d'hydroxyde de nickel dans une atmosphère réductrice à une température de 270 à 330 °C pour l'obtention de particules Ni / NiO sphériques partiellement réduites,
c) la fabrication d'une pâte à partir des particules Ni / NiO obtenues et d'un liant organique et / ou inorganique et éventuellement d'autres excipients,
d) le revêtement de la pâte sur un support,
e) la récuisson du support revêtu dans une atmosphère réductrice à des températures de 500 à 800 °C, et
f) la séparation du support pour l'obtention de la couche de nickel poreuse autoportante.

3. Electrode de nickel ou couche de nickel autoportante selon la revendication 1 ou 2, dans laquelle les particules d'hydroxyde de nickel pourvues à l'étape a) ont une taille de particule moyenne de 0,3 à 75 µm, de préférence de 3 à 30 µm, davantage de préférence de 9 à 12 µm, particulièrement de préférence 10 µm.

4. Electrode de nickel ou couche de nickel autoportante selon au moins l'une des revendications précédentes, dans laquelle la réduction partielle de l'étape b) est effectuée à des températures de 290 à 310 °C.

5. Electrode de nickel ou couche de nickel autoportante selon au moins l'une des revendications précédentes, dans laquelle on effectue la réduction partielle à l'étape b) et le traitement thermique à l'étape e) dans une atmosphère réductrice comprenant 10 à 100% d'hydrogène et éventuellement un gaz inerte.

6. Electrode de nickel ou couche de nickel autoportante selon au moins l'une des revendications précédentes, dans laquelle des polymères naturels et / ou synthétiques ou leurs dérivés sont utilisés en tant que liants organiques à l'étape c) et des sels d'ammonium ou des sels d'hydrazine en tant que liants inorganiques.

7. Electrode de nickel ou couche de nickel autoportante selon au moins l'une des revendications précédentes, dans laquelle la couche de nickel de l'électrode de nickel ou de la couche de nickel autoportante a une épaisseur dans la plage de 1 à 1.000 µm, de préférence de 10 à 900 µm, davantage de préférence de 20 à 200 µm.

8. Electrode de nickel ou couche de nickel autoportante selon au moins l'une des revendications précédentes, dans laquelle les particules de nickel poreuses et sphériques ont une taille moyenne de 0,1-25 µm, de préférence de 1 à 10 µm, mieux de 2 à 6 µm, de manière particulièrement préférée de 3 à 4 µm.

9. Procédé de production d'une électrode de nickel selon au moins l'une quelconque des revendications 1 à 8, comprenant les étapes consistant en:
a) la fourniture de particules sphériques d'hydroxyde de nickel;
b) la réduction partielle des particules sphériques d'hydroxyde de nickel dans une atmosphère réductrice à des températures de 270 à 330 °C pour l'obtention de particules Ni / NiO sphériques partiellement réduites,
c) la fabrication d'une pâte à partir des particules de Ni / NiO obtenues et d'un liant organique et / ou inorganique et éventuellement d'autres excipients,
d) le revêtement de la pâte sur une ou les deux faces de la feuille de nickel électriquement conductrice, et
e) la récuisson la feuille de nickel revêtue dans une atmosphère réductrice à des températures de 500 à 800 °C.

10. Procédé de production d'une couche de nickel autoportante selon au moins l'une quelconque des revendications 2 à 8, comprenant les étapes consistant en:
a) la fourniture de particules sphériques d'hydroxyde de nickel
b) la réduction partielle des particules sphériques d'hydroxyde de nickel dans une atmosphère réductrice à une température de 270 à 330 °C pour l'obtention de particules Ni / NiO sphériques partiellement réduites,
c) la fabrication d'une pâte à partir des particules Ni / NiO obtenues et d'un liant organique et / ou inorganique et éventuellement d'autres excipients,
d) le revêtement de la pâte sur un support,
e) la récuisson du support revêtu dans une atmosphère réductrice à des températures de 500 à 800 °C, et
f) la séparation du support pour l'obtention de la couche de nickel poreuse autoportante.

11. Utilisation de l'électrode au nickel selon au moins l'une des revendications 1 à 8 comme électrode de travail dans des batteries, des accumulateurs, des condensateurs à double couche symétrique et asymétrique, des capteurs, des supports de catalyseurs, comme électrodes dans des synthèses électrochimiques ou dans des dispositifs photoélectriques et photocatalytiques, en particulier pour l'électrolyse de l'eau en milieu alcalin.

12. Utilisation de la couche de nickel autoportante selon au moins l'une des revendications 2 à 8 comme électrode pour électrolyse de l'eau.
